(19) Europäisches Patentamt

European Patent Office

Office européen des brevets

(11) **EP 4 488 760 A1**

(12) **EUROPEAN PATENT APPLICATION**

(43) Date of publication:
**08.01.2025 Bulletin 2025/02**

(21) Application number: **23183790.7**

(22) Date of filing: **06.07.2023**

(51) International Patent Classification (IPC):
***G03F 7/20*** (2006.01)        ***H01L 21/683*** (2006.01)

(52) Cooperative Patent Classification (CPC):
**G03F 7/707; G03F 7/70708; H01L 21/6833;**
**H01L 21/6875**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventors:
• **POIESZ, Thomas**
**5500 AH Veldhoven (NL)**

• **ENGELEN, Johannes, Bernardus, Charles**
**5500 AH Veldhoven (NL)**
• **VAN DE VEN, Bastiaan, Lambertus, Wilhelmus,**
**Marinus**
**5500 AH Veldhoven (NL)**
• **VAN ROOIJ, René, Adrianus**
**5500 AH Veldhoven (NL)**

(74) Representative: **ASML Netherlands B.V.**
**Corporate Intellectual Property**
**P.O. Box 324**
**5500 AH Veldhoven (NL)**

(54) **ELECTROSTATIC CLAMP ARRANGEMENT**

(57) An electrostatic clamp arrangement comprising: a clamp member comprising a main body defining a plurality of clamp cells; wherein each clamp cell comprises: at least two raised support portions of the main body which define a recess between them; and an electrostatic sheet located in the recess, wherein the electrostatic sheet comprises an electrode and a dielectric layer; and an actuator mechanically coupled to said electrostatic sheet and configured to exert a force on said electrostatic sheet to move said electrostatic sheet relative to said raised support portions.

FIG. 3

EP 4 488 760 A1

**Description**

<u>FIELD</u>

The present invention relates to an electrostatic clamp arrangement. In particular, the electrostatic clamp arrangement may be configured to clamp an object such as a lithographic substrate. The electrostatic clamp arrangement may form part of a lithographic apparatus or lithographic tool.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A substrate which is being patterned by a lithographic apparatus is held on a movable substrate table. The substrate table includes a clamp arrangement which is configured to securely hold the substrate on the substrate table whilst the substrate is being patterned, and then to allow the substrate to be removed from the substrate table once patterning has been completed. In an EUV system the clamp arrangement is an electrical (or electrostatic) clamp (conventional vacuum clamps cannot be used because the EUV lithographic apparatus uses a vacuum environment). A problem which may arise in relation to existing clamp arrangements is that, because the clamp arrangement is the final interface to the substrate, any deformations added by the clamp arrangement which affect the flatness of the substrate are high frequency and hard to correct by any other modules within the lithographic apparatus. Any deviation in the flatness of the substrate may result in errors in the patterning of the substrate by the lithographic apparatus. Current designs of clamp arrangement include raised support portions known as burls which contact the substrate clamped by the clamp arrangement in order to support the substrate. In an attempt to minimise the burls on a clamp are designed for minimising deviation in the flatness of the substrate by the burls having passive stability - such passive stability may take the form of the burls having high stiffness and/or the burls being machined so that they have a high uniformity of flatness over the entire supported surface area of the clamped substrate.

It may be desirable to address the above problem in a manner which is not disclosed or suggested by the prior art.

<u>SUMMARY</u>

According to a first aspect of the invention there is provided an electrostatic clamp arrangement comprising: a clamp member comprising a main body defining a plurality of clamp cells; wherein each clamp cell comprises: at least two raised support portions of the main body which define a recess between them; and an electrostatic sheet located in the recess, wherein the electrostatic sheet comprises an electrode and a dielectric layer; and an actuator mechanically coupled to said electrostatic sheet and configured to exert a force on said electrostatic sheet to move said electrostatic sheet relative to said raised support portions.

Said actuator may be one of a plurality of actuators, such that each clamp cell comprises a respective one of the plurality of actuators.

Each actuator may be mechanically coupled to said electrostatic sheet of its respective clamp cell.

Each actuator may be configured to exert a force on said electrostatic sheet of the respective clamp cell to move said electrostatic sheet of the respective clamp cell relative to said raised support portions of the respective clamp cell.

A first portion of the or each actuator may be mechanically coupled to said electrostatic sheet by adhesive.

The or each actuator may be mechanically coupled to an actuator support portion of the main body.

The or each actuator may comprise a second portion which is mechanically coupled to the actuator support portion by adhesive.

The actuator support portion may define said recess of one of said plurality of clamp cells.

The or each actuator may be a piezo or reluctance actuator.

For each clamp cell, the actuator may be located in the recess and beneath the electrostatic sheet, such that the actuator is between the electrostatic sheet and a portion of the main body that defines the recess.

The electrostatic clamp arrangement may further comprise a second actuator located in said recess.

The second actuator may be mechanically coupled to the first raised support portion.

The second actuator may be configured to exert a force on said first raised support portion to move said first raised support portion relative to said second raised support portion.

According to a second aspect of the invention there is provided an electrostatic clamp arrangement comprising: a clamp member comprising a main body defining a plurality of clamp cells; wherein each clamp cell comprises: at least two raised support portions of the main body which define a recess between them; and an actuator located in said recess, the actuator being mechanically coupled to the first raised support portion and configured to exert a lateral force on said first raised support portion to move said first raised support portion relative to said second raised support portion.

The or each actuator may be mechanically coupled to an actuator support portion of the main body.

The actuator support portion may define said recess of one of said plurality of clamp cells.

The actuator may be a piezo or reluctance actuator.

An electrostatic sheet, comprising an electrode and a dielectric layer, may be located in said recess.

The actuator may be located beneath the electrostatic sheet, such that the actuator is between the electrostatic sheet and a portion of the main body that defines the recess.

The or each electrostatic sheet may comprise an aperture, wherein each aperture has an associated electromagnetic radiation sensor located in the recess beneath the electrostatic sheet, the electromagnetic radiation sensor being configured to receive electromagnetic radiation which has passed through the aperture.

The electrostatic clamp arrangement may further comprise a source of electromagnetic radiation wherein the source of electromagnetic radiation is configured to produce electromagnetic radiation and direct it through the or each aperture so that the electromagnetic radiation is received by the or each associated electromagnetic radiation sensor.

The or each electromagnetic radiation sensor may be configured to emit a first signal which is indicative of a property of the received electromagnetic radiation, said property of the received electromagnetic radiation being a function of a position of the respective electrostatic sheet having said aperture through which the received electromagnetic radiation has passed.

The electrostatic clamp arrangement may further comprise a controller configured to receive the or each first signal and, based on said the or each first signal, produce a control signal and transmit said control signal to the or each actuator and thereby control an actuation state of the or each actuator.

According to a third aspect of the invention there is provided a lithographic apparatus comprising an electrostatic clamp arrangement according to any preceding aspect of the invention.

The lithographic apparatus may further comprise an illumination system and a projection system.

According to a fourth aspect of the invention there is provided a method of operating an electrostatic clamp arrangement, the electrostatic clamp arrangement comprising: a clamp member comprising a main body defining a plurality of clamp cells; wherein each clamp cell comprises: at least two raised support portions of the main body which define a recess between them; and an electrostatic sheet located in the recess, wherein the electrostatic sheet comprises an electrode and a dielectric layer; and a power supply electrically connected to the electrode; and an actuator mechanically coupled to said electrostatic sheet; the method comprising: placing a workpiece on said at least two raised support portions; the power supply placing the electrode at a voltage and thereby generate an electrostatic force which holds the workpiece against the at least two raised support portions; and actuating the actuator to exert a force on said electrostatic sheet to move said electrostatic sheet relative to said raised support portions.

According to a fifth aspect of the invention, there is provided a method of operating an electrostatic clamp arrangement, the electrostatic clamp arrangement comprising: a clamp member comprising a main body defining a plurality of clamp cells; wherein each clamp cell comprises: at least two raised support portions of the main body which define a recess between them; and an actuator located in said recess, the actuator being mechanically coupled to the first raised support portion; the method comprising: placing a workpiece on said at least two raised support portions; and actuating the actuator to exert a force on said first raised support portion to move said first raised support portion relative to said second raised support.

According to a sixth aspect of the invention there is provided an electrostatic clamp arrangement comprising: a main body, a raised support portion extending from the body, an electrode, a sensor configured to sense a non-contact signal, an actuator mechanically linked to the electrode and/or raised support portion and a controller configured to receive a sensor signal produced by the sensor in response to the sensed non-contact signal and in response to the sensor signal produce an actuator control signal which is provided to the actuator to control the actuator to displace the electrode or/and the raised support portion with respect to the body.

The non-contact signal may comprise an electromagnetic signal or an acoustic signal.

Features of different aspects of the invention may be combined together, where the person skilled in the art deems it to be appropriate.

BRIEF DESCRIPTION OF THE DRAWINGS

Embodiments of the invention will now be described, by way of example only, with reference to the accompanying schematic drawings, in which:

- Figure 1 schematically depicts a lithographic system comprising a lithographic apparatus and a substrate table according to an embodiment of the invention;
- Figure 2 shows a schematic side view of a portion of a known clamp arrangement;
- Figure 3 shows a schematic side view of a portion of a clamp arrangement in accordance with an embodiment of the present invention;

- Figure 4 shows a schematic side view of a portion of a clamp arrangement in accordance with an embodiment of the present invention, which includes a sensor arrangement;
- Figure 5 shows a schematic side view of a portion of a clamp arrangement in accordance with another embodiment of the present invention, in which a raised support portion is in an unactuated state;
- Figure 6 shows a schematic side view of the portion of a clamp arrangement shown in Figure 5, in which a raised support portion is in an unactuated state; and
- Figure 7 shows a schematic plan view of a portion of clamp arrangement in accordance with an embodiment of the present invention.

DETAILED DESCRIPTION

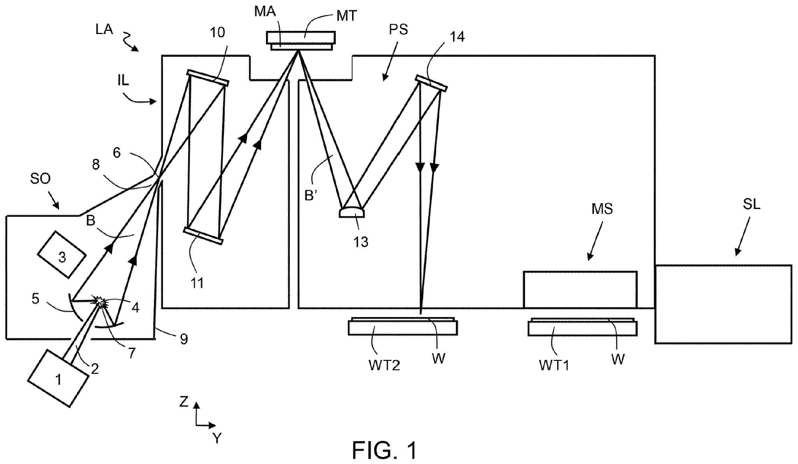

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS, a measurement system MS, and a substrate loading system SL. The lithographic system further comprises two substrate tables WT1, WT2 which are configured to support a substrate W. Each substrate table WT1, WT2 may be according to an embodiment of the invention. The support structure MT may be according to an embodiment of the invention. As explained further below, the substrate clamp may comprise an electrostatic clamp and a Johnsen-Rahbek clamp.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT2. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the environment of the projection system PS (which may also contain the measurement system MS).

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

The measurement system MS of the lithographic apparatus is configured to perform measurements of properties of a substrate W held on a substrate table WT1. The measurement system MS comprises an alignment system, which is configured to measure the positions of alignment marks on the substrate with reference to alignment marks on the substrate table WT1. The measurement system further comprises a level sensor which is configured to measure the topology of the substrate W. These measured properties are used to ensure accuracy when a pattern is subsequently projected onto the substrate W.

The lithographic apparatus LA is a dual-stage lithographic apparatus. That is, the lithographic apparatus includes two substrate tables WT1, WT2 and is configured such that a substrate W held on one of the substrate tables WT1 is measured by the measurement system MS simultaneously with a pattern being applied to a substrate W held on the other substrate table WT2. For ease of terminology, one of the substrate tables WT1 may be referred to as a first substrate table, and the other substrate table WT2 may be referred to as a second substrate table. Dual-stage lithographic apparatus advantageously provide higher throughput (i.e. exposure of substrates per hour) than single stage lithographic apparatus (which generally perform measurements simultaneously with exposure of a substrate). Once the substrate W held on the first substrate table WT1 has been measured, and the substrate W held on the second substrate table WT2 has been exposed, the substrate table WT1 supporting the measured substrate W is moved to be beneath the projection system PS. At the same time, the exposed substrate W supported by the second substrate table WT2 is moved to the substrate loading system SL.

The substrate loading system SL includes a substrate handler (not depicted) which is configured to remove the patterned substrate W from the second substrate table WT2, and then load a new substrate to be patterned onto the second substrate table. Once the substrate has been loaded onto the second substrate table WT2, the measurement system MS is used to measure alignment mark positions and the topology of the substrate. Simultaneously, the substrate W held on the first substrate table WT1 is exposed by the lithographic apparatus.

The above method is repeated many times in order to expose many substrates using the lithographic apparatus.

Each substrate table WT1, WT2 comprises a substrate clamp arrangement according to an embodiment of the invention. The substrate clamp is switched off before an exposed substrate is to be removed from the substrate table, thereby allowing a substrate handler of the substrate loading system to easily remove the substrate from the substrate table. An unexposed substrate is then placed on the substrate table WT1 (or WT2), following which the substrate clamp is switched on.

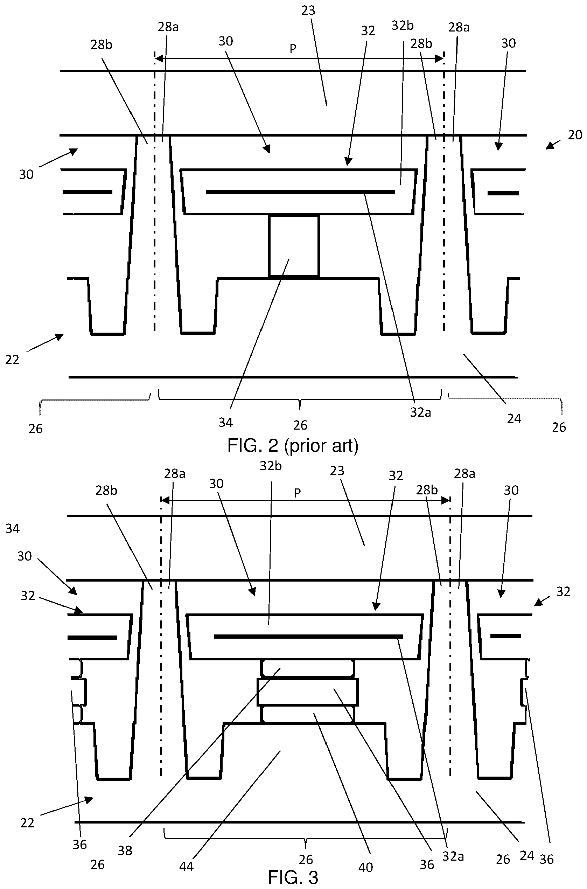

Figure 2 shows a schematic view of a portion of a known substrate clamp arrangement 20. The clamp arrangement is shown supporting a substrate 23 which can be clamped by the clamp arrangement 20. The clamp arrangement 20 is an electrostatic clamp arrangement in light of the fact that it operates to clamp the substrate by virtue of electrostatic force.

The clamp arrangement 20 comprises a clamp member 22 which includes a main body 24 defining a plurality of clamp cells 26. Each clamp cell includes two raised support portions 28a, 28b of the main body 24 which define a recess 30 between them. The raised portions may be referred to as burls. A single burl may form a raised portion of several clamp cells. In the present example the spacing P between adjacent burls is approximately 1.5mm.

An electrostatic sheet 32 is located in the recess 30. The electrostatic sheet 32 comprises an electrode 32a and a dielectric layer 32b. In the present example the dielectric layer 32b encapsulates the electrode 32a. The electrode can be formed from any suitable electrically conductive material, such as a metal. Likewise, the dielectric layer may be formed from any appropriate dielectric material. As is well known, a dielectric material is one that is an electrical insulator that can be polarized by applying an electric field to it. Examples of suitable dielectric material include silicon oxide, diamond, boron nitride, zircon oxide, aluminum nitride, silicon nitride and quartz. Whilst in the present example the electrode is encapsulated by the dielectric layer, in embodiments of the invention the dielectric layer may only adjoin part of the outer surface of the electrode.

In known clamp arrangements the electrostatic sheet 32 is held immovably within the recess 30. In particular, the electrostatic sheet 32 is fixed to a sheet support portion 34 of the main body 24. The electrostatic sheet 32 is rigidly fixed to the sheet support portion 34 by adhesive. However, it will be appreciated that in other examples any arrangement for rigidly connecting the electrostatic sheet 32 to the sheet support portion 34 of the main body 24 may be used.

In use, a power supply (not shown) is connected to the electrode 32a of the electrostatic sheet 32 so as to generate an electromagnetic field and clamp the substrate 23 to the clamp member 22 using electrostatic attraction. In the example shown, the electrostatic sheet 32 may be said to be a monopole design as it only includes a single electrode. However, in some embodiments of the invention, the electrostatic sheet may be said to be bipolar on account of the electrostatic sheet including two separate electrodes which are driven by a power supply so as to have the same magnitude of potential, but opposite polarity.

As previously mentioned, in use, a power supply is used to drive the electrode 32a within the electrostatic sheet 32 to a desired electric potential. The voltage applied to the electrode 32a within the electrostatic sheet 32 creates an electrostatic force which attracts the substrate 23 towards the clamp arrangement 20 and, in particular, clamps the substrate 23 against the raised support portions 28a, 28b of the main body 24 of the clamp member 22.

The clamping pressure between the clamp arrangement and the clamped substrate is defined by the equation below:

$$P = \frac{F}{A} = \frac{1}{2}\eta \frac{\varepsilon_0}{\left(g+\frac{d}{\varepsilon_r}\right)}V^2 \quad (1)$$

where

P is the clamping pressure,
F is the electrostatic force,
A is the area over which the electrostatic clamping force is distributed,
$\eta$ is an electrode/barrier ratio,
$\varepsilon_0$ is the dielectric constant of the vacuum between the clamp member 22 and the clamped substrate 23,
$\varepsilon_r$ is the relative dielectric constant of the dielectric material 32b of the electrostatic sheet 32 which encapsulates the electrode 32a,
g is the vacuum gap (i.e. the separation between an underside of the clamped substrate 23 and the electrostatic sheet 32),
d is the thickness of the dielectric material 32b of the electrostatic sheet 32 (this is the distance, through the dielectric material, between the electrode 32a and the vacuum gap located between the clamped substrate 23 and electrostatic sheet 32), and
V is the voltage (with respect to earth) applied to the electrode 32a of the electrostatic sheet 32.

In one example the clamping pressure exerted on the clamped substrate is approximately 40 kPa.

As previously discussed, in order for the lithographic apparatus to process the substrate correctly, it is imperative that the clamp arrangement supports the substrate in a manner such that the substrate is maintained substantially perfectly flat. However, manufacturing the clamp arrangement such that the burls provide a perfectly flat support surface across the entire surface of the supported substrate is not always possible. What is more, it is possible that the burls would become worn in an uneven manner such that, over time, the ability of the clamp arrangement to support the substrate such that it is perfectly flat over time degrades. In addition, it is possible that, over time, contaminants will find their way onto the support portions (burls) and/or substrate - again, this may result in the burls supporting the substrate in a manner which is undesirably not perfectly flat. Finally, a lack in uniformity of the thickness of the supported substrate itself may lead to an undesirable lack of flatness of the supported substrate. In light of the previously discussed problems, it is advantageous for there to be a clamp arrangement which can improve the flatness of the supported substrate over the lifetime of operation of the clamp arrangement.

It can be seen from equation 1 above that, in order to change the clamping pressure, all of the variables are set by fixed physical properties of the system other than the applied voltage V and vacuum gap g. In some applications, it may be desirable to maintain the applied voltage constant. In such applications, one way of changing the clamping pressure would be to change the vacuum gap.

In the numeric example of clamping pressure given above, it is estimated that a change in vacuum gap of the $\mu$m order of magnitude will result in a change in clamping pressure of the order of magnitude of approximately 10%. It follows that making a very small change in vacuum gap can result in a significant change in clamping pressure.

It may be desirable to control the clamping pressure in situations where changing the clamping pressure locally across the clamped substrate will enhance the flatness of the clamp substrate. For example if the clamped substrate is not flat in a particular area because it is sitting relatively high away from the clamp arrangement, it may be desirable to increase the clamping pressure in that area so as to bring that region of the substrate closer to the clamp arrangement and thereby restore the flatness of the substrate in that area.

In addition or alternatively, certain characteristics of the clamp arrangement which define the clamping pressure may change over time. For example, the raised support portions or burls of the clamp arrangement may wear, thereby decreasing their height; or the burls may become contaminated, which may increase their height. In either of these situations, this will change the spacing between the electrostatic sheet and the underside of the substrate, thereby changing the vacuum gap and hence clamping pressure. Variations in clamping pressure across the burls of the clamp arrangement may result in the clamped substrate being supported in a non-flat manner. In this case, if it is desired to return the clamping pressure to normal (i.e. the clamping pressure without burl wear or contamination), so as to ensure uniform clamping pressure across the clamped substrate, and therefore ensure flatness of the clamped substrate over its entire area, the vacuum gap can be changed. Some embodiments of the present invention achieve this by actuating an actuator which is mechanically linked to the electrostatic sheet, thereby changing the position/height of the electrostatic sheet relative to the raised support portions. This is discussed in more detail below.

Figure 3 shows a schematic view of the portion of a clamp arrangement in accordance with an embodiment of the present invention.

Equivalent features within the embodiment shown in Figure 3 to those of the example shown in Figure 2 have been given the same reference numerals. The discussion below focuses only on the differences between the embodiment shown in Figure 3 and the prior art shown in Figure 2. Structurally, there is one main difference between the embodiment shown in Figure 3 and the prior art shown in Figure 2 - instead of the electrostatic sheet 32 being rigidly fixed to the sheet support portion 34 of the main body 24, as in the prior art; in the embodiment shown in Figure 3, the electrostatic sheet 32 is mounted within the recess 30 to the main body 24 via an actuator 36.

In particular, (a first portion of) the actuator 36 is mechanically coupled to the electrostatic sheet 32. The actuator 36 is configured to exert a force on the electrostatic sheet 32 in order to move the electrostatic sheet 32 relative to the main body 24; and, in particular, relative to the raised support portions 28a, 28b. In the present embodiment, the actuator 36 is rigidly coupled to the electrostatic sheet 32 via a layer of adhesive 38. Furthermore, (a second portion of) the actuator 36 is rigidly coupled to the main body 24 by a further adhesive layer 40. It will be appreciated that, in other embodiments, any appropriate fixing may be used to join the actuator to the electrostatic sheet and main body.

Figure 3 shows a central clamp cell 26 and portions of adjacent clamp cells 26 to the left and right (as shown in the figure) of the central clamp cell 26. As such, it will be appreciated that the actuator 36 of the central clamp cell 26 is one of a plurality of actuators 36 - each of the three clamp cells 26 shown within Figure 3 comprises a respective one of the plurality of actuators 36. Each actuator 36 is mechanically coupled to the electrostatic sheet 32 of its respective clamp cell 26 and configured to exert a force on the electrostatic sheet 32 of the respective clamp cell 26 to move the electrostatic sheet 26 relative to the main body 24, and, in particular, relative to the raised support portions 28a, 28b of the respective clamp cell 26.

The portion of the main body 24 to which each of the actuators 36 is mechanically coupled may be referred to as an actuator support portion 44 of the main body. It will be appreciated that the actuator support portion 44 of each clamp cell 26 defines, at least in part, the recess 30 of the clamp cell 26.

In the present embodiment the actuator 36 in each clamp cell 26 is a piezo actuator. As is well known, a piezo actuator makes use of the inverse piezoelectric effect: whereby electrical energy is converted into mechanical energy by a piezoelectric material. Examples of piezoelectric material include certain crystals, such as quartz, and certain ceramics, such as lead zirconate titanate. It will be appreciated that any appropriate type of piezo actuator may be used, which incorporates any appropriate piezoelectric material.

Whilst the actuators used in the presently described embodiment take the form of piezo actuators, it will be appreciated that any appropriate type of actuator may be used. For example, the actuator may be a reluctance actuator.

The actuator of each clamp cell may be a linear actuator (i.e. an actuator that exhibits a linear output movement) which is configured to exert a force on the electrostatic sheet which is generally perpendicular to the plane in which the clamped substrate sits during use. In some embodiments the stroke of movement achieved by the actuator may be between about 100nm and about 5μm.

As can be seen clearly in Figure 3, for each clamp cell 26, the actuator 36 is located in the recess 30 and is located beneath the electrostatic sheet 32. In this way the actuator 36 is located between the electrostatic sheet 32 and a portion of the main body 24 which defines the recess 30. In particular, the actuator is between the electrostatic sheet 32 and the actuator support portion 44 of the main body 24.

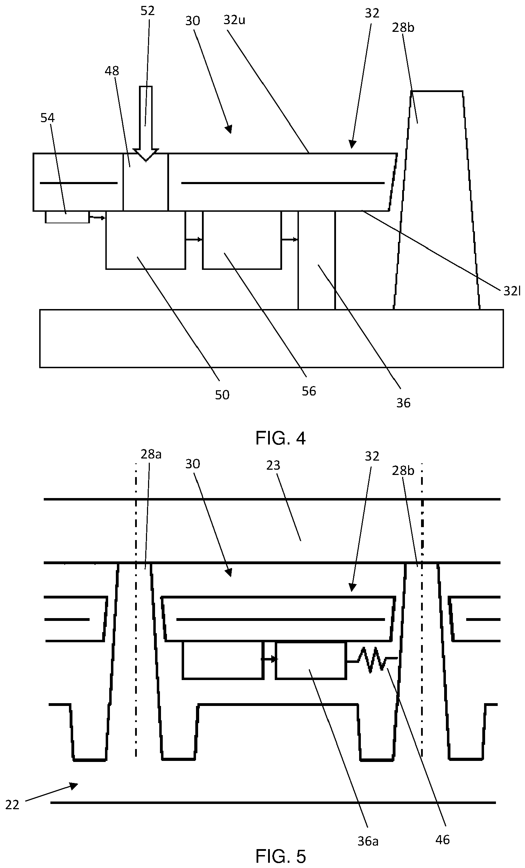

Figure 5 shows a schematic view of a portion of a clamp arrangement according to another aspect of the present invention. Again, in this embodiment, features of the embodiment which are equivalent to those shown within Figures 2 and 3 have been labelled using the same reference numerals. The main difference between the embodiment shown in Figure 5 and that shown in Figure 3 is that, instead of the actuator 36 within the embodiment shown in Figure 3 being mechanically linked to the electrostatic sheet 32 and the actuator support portion 44 of the main body so as to exert a force on the electrostatic sheet 32 which is generally perpendicular to the plane of the clamped substrate; in the embodiment shown in Figure 5, the actuator 36a is mechanically coupled to the second raised support portion 28b (although, it could equally be coupled to the first raised support portion) via connection 46, and the actuator 36a is configured to exert a lateral force (i.e. a force which is perpendicular to the normal to the plane in which the substrate clamped by the clamp arrangement lies in use) on the second raised support portion 28b, which can move the second raised support portion 28b relative to the first raised support portion 28a.

In a similar manner to the operation of the actuator in the embodiment discussed above in relation to Figure 3 (whereby the actuator changes the height of the electrostatic sheet relative to the raised support portions in order to change the vacuum gap and thereby change the clamping pressure), in the present embodiment, actuating the actuator 36a so as to move the second raised support portion 28b relative to the first raised support portion 28a will affect the height of the second raised support portion 28b and thereby change the vacuum gap between the electrostatic sheet and the clamp substrate, and thereby change the clamping pressure.

In the embodiment shown in Figure 5 the actuator is mechanically coupled to the underside of the electrostatic sheet 32. However, in other embodiments, the actuator 36a may instead be coupled to a portion of the main body 24 which defines the recess 30, such as, an actuator support portion 44 of the main body 24.

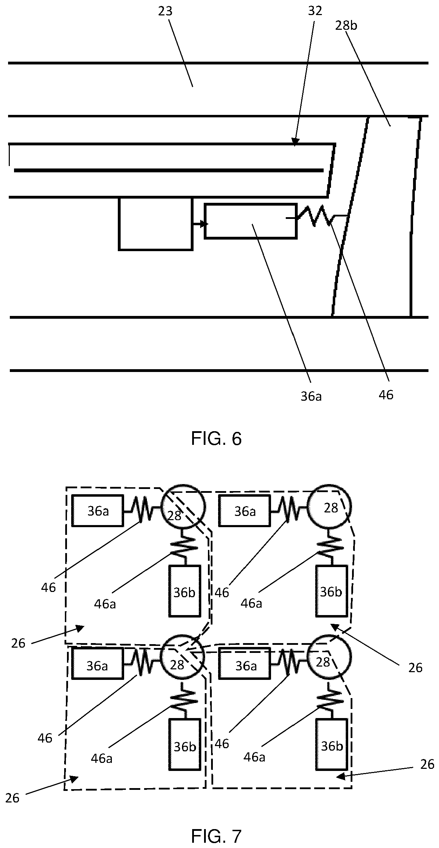

Figure 6 shows a schematic view of when the actuator 36a of the embodiment shown in Figure 5 has been actuated and exerts an lateral force (in this case a force which is from left to right in the figure) on the second raised support portion 28b. It can be seen that the actuator has exerted a force on the second raised support portion 28b so as to move the second support portion 28b relative to the first raised support portion 28a - in particular, the second raised support portion 28b has been caused to move generally away from the first raised support portion 28a in the direction from left to right as shown in the figure.

Given that the second raised support portion 28b is not a free body, but, rather, an integral part of the main body 24, the movement of the portion of the second raised support portion 28b which, in use, supports the clamped substrate, caused by a lateral force exerted by the actuator 36a will be complex. However, for ease of explanation, a component of the movement of this portion of the second raised support portion 28b caused by the actuator 36a will be in the lateral direction (left to right within the figure) and a component of the movement of this portion of the second raised support portion 28b caused by the actuator 36a will be in the normal direction (up to down within the figure). It will be appreciated that by controlling the actuator 36a to control the lateral force exerted on the secondary support portion 28b it is possible to control the position of the second raised support portion 28b (and in particular the portion of the second raised support portion which, in use, contacts the clamped substrate) in relation to the first raised support portion 28a. The ability to control the position of the second raised support portion 28b using the actuator 36a means that it is possible to control the position of the portion of the second raised support portion 28b which, in use, contacts the clamped substrate. It follows that the actuator 36a can be controlled to move the second raised support portion 28b so that it supports the clamped substrate in a manner which maximizes the flatness of the clamped substrate.

The embodiment shown in Figures 5 and 6 only shows an actuator 36a located within a single clamp cell 26. Furthermore, Figure 5 only shows the position of the relevant clamp cell 26 within a generally one-dimensional row of clamp cells. In other embodiments the clamp arrangement may be relatively two-dimensional such that there is a two-dimensional array of rows and columns of clamp cells each having corresponding raised support portions or burls (such that the raised support portions themselves form a relatively two-dimensional array). In embodiments in which the clamp cells form a relatively two dimensional array, the recess of each clamp cell between the raised support portions will have a footprint which is relatively two- dimensional - having width and depth - such that the footprint is generally rectangular. It follows that the space (which may be equivalent to the recess of each clamp cell) defined between the raised support portions having such a footprint may be generally cuboidal. Although this relatively two-dimensional arrangement of clamp cells has been discussed in relation to the embodiment shown in Figures 5 and 6, it may also apply to any of the embodiments of the invention discussed within the present application (for example those discussed in relation to Figures 3 and 4).

Figure 7 shows a schematic plan view of a portion of a clamp arrangement in accordance with an embodiment of the present invention. This portion of the clamp arrangement includes four burls 28 which form raised support portions of a number of clamp cells 26. Each burl 28 has a first actuator 36a connected to it via a mechanical connection 46, and a second actuator 36b connected to it by a mechanical connection 46a. It can be seen that, in the case of each burl, the first actuator 36a is connected to the burl 28 so that it is generally perpendicular to the second actuator 36b. It will be appreciated that by connecting two actuators to each burl such that the actuators (and, in particular, an actuation direction of each actuator) are perpendicular to one another, by controlling the actuation state of each of the actuators, this gives greater control over the position of each of the burls (and, in particular, the position of the portion of each of the burls which, in use, contacts the clamped substrate). For example, by controlling the actuation state of each of the first actuators 36a it is possible to control the position of each burl individually in the left-right direction as shown in the figure. In addition, by controlling the actuation state of each of the second actuators 36b, it is possible to individually control the position of each burl individually in the up-down direction as shown in the figure.

It will be appreciated that the embodiment of the present invention discussed above in relation to Figure 3 (in which an actuator 36 is used to actuate the position of the electrostatic sheet 32) may be combined with the embodiment of the invention discussed in relation to Figures 5 to 7 (in which the actuator 36a is used to actuate the position of a raised support portion 28b). In this situation, in each clamp cell, a first actuator will be mechanically coupled to the electrostatic sheet and configured to exert force on the electrostatic sheet to move the electrostatic sheet relative to the raised support portions. A second actuator will also be located in the recess of each clamp cell, the second actuator being mechanically coupled to one of the raised support portions of the clamp cell and configured to exert a force on said one of the raised support portions to move said one of the raised support portions relative to another raised support portion. Such an arrangement provides greater flexibility to control the vacuum gap by controlling both the position of the electrostatic sheet and the position of the actuated raised support portion.

Figure 4 shows a schematic view of a portion of a clamp arrangement in accordance with an embodiment of the present invention. This figure is used to illustrate a sensor arrangement which may be utilized in combination with the embodiment of the invention shown in Figure 3 (in which the actuator actuates the electrostatic sheet). However, it will be appreciated that the sensor arrangement described below could equally be used in combination with the embodiment of the invention shown in Figures 5 to 7 (in which the actuator actuates the raised support portion, or burl).

The electrostatic sheet 32, located within the recess 30 defined between the raised support portions (one of which is shown - 28b), comprises an aperture 48. The aperture 48 passes from an upper surface 32u of the electrostatic sheet 32, through the electrostatic sheet 32 to a lower surface 321 of the electrostatic sheet 32. In use the upper surface 32u faces the clamped substrate (not shown in Figure 4) and the lower surface 321 faces away from the upper surface 32u, towards the portion of the main body 24 which defines the recess 30.

The aperture 48 has an associated electromagnetic radiation sensor 50 located in the recess 30 beneath the electrostatic sheet 32. The sensor 50 is configured to receive electromagnetic radiation 52 which has passed through the aperture 48.

A common power rail provides power to the sensor 50. The power rail 54 may also provide power to the other powered components of the system located within the recess 30. The sensor 50 provides a sensor signal which is indicative of a property of the electromagnetic radiation sensed by the sensor 50.

A controller 56 is configured to receive the signal produced by the sensor 50 and, based on the signal received from the sensor 50, produce a control signal which is transmitted to the actuator 36 to thereby control an actuation state of the actuator 36. As previously discussed, the actuator 36 actuates the electrostatic sheet 32 and hence the actuation state of the actuator 36 determines the position of the electrostatic sheet 32 (and hence the vacuum gap and thereby the clamping pressure).

The electrostatic clamp arrangement may further comprise a source of electromagnetic radiation (not shown). The source of electromagnetic radiation is configured to produce said electromagnetic radiation 52 and direct it through the aperture 48 so that the radiation 52, is incident on the associated sensor 50. If the substrate to be clamped is substantially opaque to the electromagnetic radiation produced by the source of electromagnetic radiation, then it may be necessary for the substrate to not be clamped by the clamp arrangement in order to allow the electromagnetic radiation produced by the source of electromagnetic radiation to pass to the aperture 48 and hence the sensor 50. However, if the type of radiation is chosen (for example, the use of infrared radiation) such that the clamped substrate is not substantially opaque to the electromagnetic radiation used, then it will be possible for the electromagnetic radiation to pass to the aperture and hence to the sensor 50 whilst the clamped substrate is in use.

The sensor 50 is configured such that the sensor signal emitted by the sensor 50 is indicative of a property of the received electromagnetic radiation 52. The property of the received electromagnetic radiation is a function of a position of the electrostatic sheet (for example the height of the electrostatic sheet 32 relative to a portion of the main body 24). In this way, the signal produced by the sensor 50 which is received by the controller 56 is indicative of the position of the electrostatic sheet 32, thereby allowing the controller to determine what control signal to send to the actuator 36 in order to place the actuator in a desired actuation state so as to control the actuator to place the electrostatic sheet 32 at a desired position.

It can be appreciated that whilst in the described embodiment the sensor senses electromagnetic radiation (or an electromagnetic signal), in other embodiments the sensor may sense any appropriate form of non-contact signal which passes through the aperture in the electrostatic sheet. The non-contact signal may, as already discussed, be an electromagnetic signal. Alternatively, the non-contact signal may be an acoustic signal.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference has been made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions. A substrate clamp according to an embodiment of the invention may form part of a lithographic tool.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. An electrostatic clamp arrangement comprising:

   a clamp member comprising a main body defining a plurality of clamp cells; wherein each clamp cell comprises:

   at least two raised support portions of the main body which define a recess between them; and
   an electrostatic sheet located in the recess, wherein the electrostatic sheet comprises an electrode and a dielectric layer; and

   an actuator mechanically coupled to said electrostatic sheet and configured to exert a force on said electrostatic sheet to move said electrostatic sheet relative to said raised support portions.

2. An electrostatic clamp arrangement according to claim 1, wherein said actuator is one of a plurality of actuators, such that each clamp cell comprises a respective one of the plurality of actuators, each actuator being mechanically coupled to said electrostatic sheet of its respective clamp cell and being configured to exert a force on said electrostatic sheet of the respective clamp cell to move said electrostatic sheet of the respective clamp cell relative to said raised support portions of the respective clamp cell.

3. An electrostatic clamp arrangement according to claim 1 or claim 2, wherein a first portion of the or each actuator is mechanically coupled to said electrostatic sheet by adhesive.

4. An electrostatic clamp arrangement according to any preceding claim, wherein the or each actuator is mechanically coupled to an actuator support portion of the main body; and, optionally, wherein the or each actuator comprises a second portion which is mechanically coupled to the actuator support portion by adhesive.

5. An electrostatic clamp arrangement according to claim 4, wherein the actuator support portion defines said recess of one of said plurality of clamp cells.

6. An electrostatic clamp arrangement according to any preceding claim, wherein the or each actuator is a piezo or reluctance actuator.

7. An electrostatic clamp arrangement according to claim 2 or any preceding claim dependent on claim 2, wherein for each clamp cell, the actuator is located in the recess and beneath the electrostatic sheet, such that the actuator is between the electrostatic sheet and a portion of the main body that defines the recess.

8. An electrostatic clamp arrangement according to any preceding claim, further comprising a second actuator located in said recess, the second actuator being mechanically coupled to one of said raised support portions and configured to exert a force on said one of said raised support portions to move said one of said raised support portions relative to another of said raised support portions.

9. An electrostatic clamp arrangement comprising:
   a clamp member comprising a main body defining a plurality of clamp cells; wherein each clamp cell comprises:

   at least two raised support portions of the main body which define a recess between them; and
   an actuator located in said recess, the actuator being mechanically coupled to the first raised support portion and configured to exert a lateral force on said first raised support portion to move said first raised support portion relative to said second raised support portion.

10. An electrostatic clamp arrangement according to claim 9, wherein the or each actuator is mechanically coupled to an actuator support portion of the main body.

11. An electrostatic clamp arrangement according to claim 10, wherein the actuator support portion defines said recess of one of said plurality of clamp cells.

12. An electrostatic clamp arrangement according to any of claims 9 to 11, wherein an electrostatic sheet, comprising an electrode and a dielectric layer, is located in said recess.

13. An electrostatic clamp arrangement according to claim 12, wherein the actuator is located beneath the electrostatic sheet, such that the actuator is between the electrostatic sheet and a portion of the main body that defines the recess.

14. An electrostatic clamp arrangement according to any of claims 1 to 8 or 12 or 13, wherein the or each electrostatic sheet comprises an aperture, wherein each aperture has an associated electromagnetic radiation sensor located in the recess beneath the electrostatic sheet, the electromagnetic radiation sensor being configured to receive electromagnetic radiation which has passed through the aperture.

15. A lithographic apparatus comprising an electrostatic clamp according to any of claims 1 to 14.

FIG. 1

FIG. 2 (prior art)

FIG. 3

FIG. 4

FIG. 5

23    32    28b

36a    46

FIG. 6

36a    28    36a    28

46    46a    36b    46    46a    36b

26    26

36a    28    36a    28

46    46a    36b    46    46a    36b

26    26

FIG. 7

Europäisches
Patentamt

European
Patent Office

Office européen
des brevets

# EUROPEAN SEARCH REPORT

Application Number

EP 23 18 3790

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2022/195036 A1 (ASML NETHERLANDS BV [NL]) 22 September 2022 (2022-09-22)<br>* paragraphs [0099] – [0104]; figure 5 * | 1-15 | INV.<br>G03F7/20<br>H01L21/683 |
| A | US 2020/321233 A1 (ZIEGENHAGEN LARS [DE] ET AL) 8 October 2020 (2020-10-08)<br>* paragraphs [0004], [0016], [0054] – [0059]; figures 1, 2 * | 1-15 | |
| A | US 2005/030515 A1 (OTTENS JOOST JEROEN [NL] ET AL) 10 February 2005 (2005-02-10)<br>* paragraphs [0007], [0032] – [0046]; figures 3-5 * | 1-15 | |

TECHNICAL FIELDS
SEARCHED      (IPC)

G03F
H01L

The present search report has been drawn up for all claims

| Place of search | Date of completion of the search | Examiner |
|---|---|---|
| Munich | 5 December 2023 | Eisner, Klaus |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

**EP 23 18 3790**

This annex lists the patent family members relating to the patent documents cited in the above-mentioned European search report.
The members are as contained in the European Patent Office EDP file on
The European Patent Office is in no way liable for these particulars which are merely given for the purpose of information.

**05-12-2023**

| Patent document cited in search report | Publication date | Patent family member(s) | Publication date |
|---|---|---|---|
| WO 2022195036 A1 | 22-09-2022 | TW 202243107 A | 01-11-2022 |
| | | WO 2022195036 A1 | 22-09-2022 |
| US 2020321233 A1 | 08-10-2020 | DE 102019108855 A1 | 08-10-2020 |
| | | JP 7312720 B2 | 21-07-2023 |
| | | JP 2020188253 A | 19-11-2020 |
| | | US 2020321233 A1 | 08-10-2020 |
| US 2005030515 A1 | 10-02-2005 | CN 1577109 A | 09-02-2005 |
| | | EP 1498777 A1 | 19-01-2005 |
| | | JP 4074267 B2 | 09-04-2008 |
| | | JP 2005039274 A | 10-02-2005 |
| | | KR 20050008514 A | 21-01-2005 |
| | | SG 118285 A1 | 27-01-2006 |
| | | TW I240804 B | 01-10-2005 |
| | | US 2005030515 A1 | 10-02-2005 |

EPO FORM P0459

For more details about this annex : see Official Journal of the European Patent Office, No. 12/82